# EUROPÄISCHE PATENTSCHRIFT

(11) **EP 2 200 930 B1**
(45) Veröffentlichungstag und Bekanntmachung des Hinweises auf die Patenterteilung: **30.03.2016**
(21) Anmeldenummer: 08786315.5
(22) Anmeldetag: 22.07.2008
(51) Int. Cl.: B81C 1/00

(54) **VERFAHREN ZUM AUFDRUCKEN EINER NANO- UND/ODER MIKROSTRUKTUR**
METHOD FOR PRINTING A NANOSTRUCTURE AND/OR MICROSTRUCTURE
PROCÉDÉ D'IMPRESSION D'UNE NANOSTRUCTURE ET/OU D'UNE MICROSTRUCTURE

(30) Priorität: 18.09.2007 DE 102007044504
(43) Veröffentlichungstag der Anmeldung: 30.06.2010
(73) Patentinhaber: Robert Bosch GmbH, 70442 Stuttgart (DE)
(72) Erfinder: MAY, Johanna, 70839 Gerlingen (DE)
(86) Internationale Anmeldenummer: PCT/EP2008/059579
(87) Internationale Veröffentlichungsnummer: WO 2009/037030

(56) Entgegenhaltungen:
- WO-A-2005/113422
- BAO L-R ET AL: "Nanoimprinting over topography and multilayer three-dimensional printing" JOURNAL OF VACUUM SCIENCE AND TECHNOLOGY: PART B, AVS / AIP, MELVILLE, NEW YORK, NY, US, Bd. 20, Nr. 6, 1. November 2002 (2002-11-01), Seiten 2881-2886, XP012009652 ISSN: 1071-1023
- PENG C ET AL: "Hybrid mold reversal imprint for three-dimensional and selective patterning" JOURNAL OF VACUUM SCIENCE AND TECHNOLOGY: PART B, AVS / AIP, MELVILLE, NEW YORK, NY, US, Bd. 24, Nr. 6, 30. November 2006 (2006-11-30), Seiten 2968-2972, XP012091777 ISSN: 1071-1023

## Beschreibung

### Stand der Technik

Bekannt ist das sogenannte 2D-Microcontact-Printing zum selektiven Aufstempeln einer Nano- und/oder Mikrostruktur auf ein planares Substrat. Hierzu wird ein Stempel mit einer planaren, nano- und/oder mikrostrukturierten Stempeloberfläche in eine Lösung oder Suspension einer Substanz getaucht und dann auf das planare Substrat gedrückt, um die Substanz an den erhabenen Stellen der Nano- und/oder Mikrostruktur der Stempeloberfläche auf das Substrat aufzubringen. Danach wird der Stempel wieder entfernt, wobei gegebenenfalls nachfolgende Temperaturschritte notwendig sind, um die auf diese Weise aufgebrachte Nano- und/oder Mikrostruktur auf dem Substrat zu fixieren.

Das Aufdrucken einer Nano- und/oder Mikrostruktur auf ein nicht-planares Substrat, also ein Substrat mit einer dreidimensionalen Makro-Oberfläche ist mit dem bekannten 2D-Microcontact-Printing-Verfahren nicht möglich.

Aus der WO 2005/113422 A1 ist ein Druck-Prägeverfahren für die Herstellung einer 3D-Mikrostruktur bekannt, bei der eine dreidimensionale Struktur durch einen Stempel erzeugt wird.

Aus dem Artikel J.Vac. Sci.Technol. B 20 (6), Nov/Dec 2002 L.-R. Bao et al "Nanoimprinting over topography and multilayer three-dimensional printing" ist, ebenfalls ein Erzeugen einer Mikrostruktur durch Prägestempel bekannt. Einen ähnlichen Ansatz zeigt J.Vac. Sei. Technol B 24 (6), Nov/Dec 2006 C. Peng und S. W. Pang "Hybrid mold reversal imprintfor three-dimensional and selective patterning".

### Offenbarung der Erfindung

### Technische Aufgabe

Der Erfindung liegt daher die Aufgabe zugrunde, ein Verfahren vorzuschlagen, mit dem eine Nano- und/oder Mikrostruktur auf ein Substrat mit einer dreidimensionalen Makro-Oberfläche aufgedruckt werden kann. Ferner besteht die Aufgabe darin, ein mit einem derartigen Verfahren hergestelltes Substrat mit einer Nano- und/oder Mikrostruktur vorzuschlagen.

### Technische Lösung

Diese Aufgabe wird hinsichtlich des Verfahrens mit den Merkmalen des Anspruchs 1 und hinsichtlich des Substrates mit den Merkmalen des Anspruchs 11 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Zeichnungen offenbarten Merkmalen.

Der Erfindung liegt der Gedanke zugrunde, zum Erzeugen von Nano- und/oder Mikrostrukturen auf bzw. in einem Substrat mit einer dreidimensionalen Makro-Oberfläche einen an die Makro-Oberfläche des Substrates angepassten Stempel zu verwenden, also einen Stempel, der ebenfalls eine dreidimensionale Makro-Oberfläche (Stempel-Makro-Oberfläche) aufweist, die zumindest abschnittsweise als Negativabbild der dreidimensionalen Makro-Oberfläche des Substrates ausgebildet, also formkongruent zu der Makro-Oberfläche des Substrates beschaffen ist. Unter einer Makro-Oberfläche sind dabei in einem weitesten Sinn sämtliche Oberflächen zu verstehen, die von einer zumindest näherungsweise ebenen, d.h. zweidimensionalen, planaren Makro-Oberfläche abweichen, wie sie bei bisherigen Microcontact-Printing-Verfahren, insbesondere als geschnittene, planarisierte Wafer-Oberfläche, zum Einsatz kommt. Im engeren Sinn wird unter einer Makro-Oberfläche eine im Millimeter- und/oder Zentimeter-Bereich (makro-) strukturierte Oberfläche verstanden. In einem noch engeren Verständnis handelt es sich bei einer Makro-Oberfläche um eine Oberfläche, die mindestens einen Stufenabschnitt von mindestens 10 µm Höhe aufweist. Anders ausgedrückt weist die Makro-Oberfläche (des Substrates und des Stempels) in dem engsten Verständnis Höhenunterschiede auf, die bei einer klassischen 2D-Lithographie zu einem Fokusverlust führen würden.

Um mittels des eine dreidimensionale Stempel-Makro-Oberfläche aufweisenden Stempels Nano- und/oder Mikrostrukturen auf das Substrat aufdrucken zu können, muss der Stempel zunächst, zumindest in dem Bereich, mit dem die Nano- und/oder Mikrostrukturen aufgedruckt werden sollen, also in dem Bereich, in dem auf der Stempel-Makro-Oberfläche eine Stempel-Nano- und/oder Mikrostruktur vorgesehen ist, mit der aufzudruckenden Substanz beaufschlagt werden. Das Aufbringen der aufzudruckenden Substanz kann beispielsweise durch Besprühen der Stempel-Makro-Oberfläche mit der Substanz oder Eintauchen des Stempels in die Substanz erfolgen. Dabei muss die Substanz so ausgewählt werden, dass sie sowohl an der nano- und/oder mikrostrukturierten Stempel-Makro-Oberfläche anhaftet als auch an dem zu bedruckenden Substrat. Bevorzugt weist die Substanz eine größere Affinität zu dem Substrat als zu dem Stempel auf, um eine möglichst vollständige Abgabe der Substanz in den erhöhten Strukturbereichen der Stempel-Nano- und/oder Mikrostruktur an das Substrat zu ermöglichen. Vor oder bevorzugt nach dem Aufbringen der aufzudruckenden Substanz auf den Stempel werden das Substrat und der Stempel relativ zueinander positioniert, d.h. ausgerichtet, derart, dass die dreidimensionale Stempel-Makro-Oberfläche exakt zu der positiven dreidimensionalen Makro-Oberfläche des Substrates ausgerichtet ist und der Stempel und das Substrat im Hinblick auf ihre Makro-Oberflächen nach dem Schlüssel-Schloss-Prinzip aufeinanderpassen. Um die Nano- und/oder Makrostrukturen auf dem Substrat erzeugen zu können, ist auf der dreidimensionalen Stempel-Makro-Oberfläche eine Stempel-Nano- und/oder Mikrostruktur vorgesehen. Diese kann beispielsweise durch Erodieren, Mikrofräsen oder auch Gießen, beispielsweise in PDMS (Silikonkautschuk), erzeugt werden. Nach dem relativen Ausrichten des Stempels und des Substrates zueinander erfolgt in einem weiteren Schritt das Aufdrucken der Nano- und/oder Mikrostruktur auf das Substrat durch Erzeugen einer Relativbewegung zwischen dem Stempel und dem Substrat aufeinanderzu. Diese Stempelbewegung ist vorzugsweise weggesteuert ausgeführt. Bei dem eigentlichen Stempelvorgang (Druckvorgang) wird die Substanz von den in Richtung des Substrates weisenden Erhöhungen und gegebenenfalls auch von geringen Vertiefungen auf das Substrat abgegeben und somit eine Nano- und/oder Mikrostruktur auf dem Substrat erzeugt.

Das relative Ausrichten des Stempels zu dem Substrat kann unter Zuhilfenahme mindestens eines optischen Sensors erfolgen. Diese Art der Ausrichtung bietet sich insbesondere dann an, wenn der Stempel und/oder das Substrat transparent ausgebildet sind. Falls kein optischer Zugang möglich ist, kann die Ausrichtung unter Zuhilfenahme mechanischer Sensoren erfolgen.

Das nach dem Konzept der Erfindung ausgestaltete Verfahren eignet sich für eine Vielzahl von Herstellungsverfahren. Beispielsweise ist es möglich, je nach Wahl der aufzudruckenden Substanz, mit dem nach dem Konzept der Erfindung ausgebildeten Verfahren Leiterbahnen oder elektrische Bauteile, beispielsweise auf ein Leiterplatten-Substrat aufzudrucken. Zusätzlich oder alternativ können mit dem nach dem Konzept der Erfindung ausgebildeten Verfahren Ätzstopp-Schichten für einen späteren Strukturierungsvorgang aufgestempelt werden. Ebenso ist es möglich, mit dem nach dem Konzept der Erfindung ausgebildeten Verfahren bioaktive Substanzen auf ein Substrat aufzubringen. Bei Bedarf können mehrere Druckvorgänge nacheinander, bevorzugt auch übereinander ausgeführt werden.

In Weiterbildung der Erfindung ist mit Vorteil vorgesehen, dass die aufzudruckende Substanz flüssig, insbesondere zähflüssig, vorzugsweise pastös und/oder pulverförmig ist. Die Substanz muss dabei, wie eingangs erwähnt, so beschaffen sein, dass sie sowohl an der Stempel-Makro-Oberfläche bzw. der Stempel-Nano- und/oder Mikrostruktur als auch auf dem Substrat haftet, wobei eine erhöhte Affinität zu dem Substrat von Vorteil ist.

Erfindungsgemäß umfasst die Substanz bioaktives Material, insbesondere Proteine und/oder Antikörper oder besteht ausschließlich aus bioaktivem Material. Auf diese Weise ist es möglich, ein Substrat, beispielsweise einen Fluidchip aus Polymer mit bioaktivem Schichten bzw. Mikro- und/oder Nanostrukturen zu versehen. Insbesondere durch mehrfaches Bedrucken des Substrates, gegebenenfalls an unterschiedlichen Stellen kann eine organische Elektronik und/oder unterschiedliche bioaktive Schichten auf demselben Substrat realisiert werden.

Insbesondere dann, wenn mit dem Druckverfahren elektrische Bauteile, wie Leiterbahnen und/oder Widerstände und/oder Kondensatoren, etc. auf ein, insbesondere als Leiterplatte ausgebildetes Substrat aufgedruckt werden sollen, ist es vorteilhaft, wenn die Substanz elektrisch leitfähige Partikel enthält oder ausschließlich aus solchen elektrisch leitfähigen Partikeln, beispielsweise Silberpartikeln, besteht.

Zusätzlich oder bevorzugt alternativ umfasst die Substanz ein Ätzstopp-Material oder besteht vollständig aus Ätzstopp-Material. Durch das Aufbringen von Ätzstopp-Material kann das Substrat in einem späteren, vorzugsweise nasschemischen Ätzschritt strukturiert werden, wobei bei diesem Ätzschritt vorzugsweise die nicht beschichteten Stellen des Substrates zumindest teilweise abgetragen werden. Beispielsweise ist es denkbar als Ätzstopp-Material für Gold mittels des Stempels Thiole auf ein Goldsubstrat aufzudrucken.

Je nach Beschaffenheit der aufzustempelnden Substanz kann es notwendig sein, die aufgedruckte Nano- und/oder Mikrostruktur zu fixieren. Beispielsweise kann dies je nach Substanz durch Bestrahlen und/oder Erwärmen und/oder Lagern in einer Fixiergasatmosphäre erfolgen. Insbesondere sind als aufzudruckende Substanzen Duroplaste oder UVpolymerisierbare Substanzen einsetzbar, wobei bevorzugt bei UV-polymerisierbaren Substanzen der Stempel für UV-Licht transparent ausgebildet ist.

Je nach Beschaffenheit der aufzudruckenden Substanz kann es vorteilhaft sein, wenn das Aufdrucken der Substanz auf das Substrat unter einer Vakuum- oder einer Überdruckatmosphäre durchgeführt wird, wobei unter einer Überdruckatmosphäre eine Atmosphäre mit einem Druck oberhalb des Atmosphärendrucks verstanden wird. Besonders bevorzugt ist eine Ausführungsform des Verfahrens, bei der mittels des Stempels unterschiedliche tiefe und/oder breite Nano- und/oder Mikrostrukturen in das Substrat aufgedruckt werden können, der Stempel also eine Stempel-Nano- und/oder Mikrostruktur aufweist, die unterschiedliche Tiefen- bzw. Höhenabschnitte und/oder unterschiedliche Breitenabschnitte aufweist.

Um die Komplexität der Nano- und/oder Mikrostruktur auf dem Substrat weiter zu erhöhen, ist in Weiterbildung der Erfindung mit Vorteil vorgesehen, dass nach dem Aufdrucken (Aufstempeln) der Substanz, gegebenenfalls nach einem darauffolgenden Ätzschritt und/oder Fixierschritt, mindestens eine weitere Bedruckung des Substrates mit derselben oder einer anderen Substanz, mit demselben oder einem anderen, vorzugsweise unterschiedlich nano- und/oder mikrostrukturierten Stempel erfolgt.

Das beschriebene Verfahren lässt sich auch auf Substraten anwenden, deren Makro-Oberfläche auch auf der zu bedruckenden Seite der gegenüberliegenden Seite dreidimensional makrostrukturiert ist, indem das Substrat nicht auf einer zweidimensionalen, ebenen Halterung aufliegt, sondern indem eine dreidimensionale, vorzugsweise förmkongruent zur Anlagefläche des Substrates ausgebildete Halterung vorgesehen ist.

Das erfindungsgemäße Verfahren verwendet einen Stempel zur Durchführung des zuvor beschriebenen Verfahrens. Der Stempel ist gekennzeichnet durch eine dreidimensionale Stempel-Makro-Oberfläche, die nano- und/oder mikrostrukturiert ist. Der Stempel kann dabei zumindest teilweise, insbesondere der nano- und/oder mikrostrukturierte Bereich aus PDMS ausgebildet werden, wobei in diesem Fall die Stempel-Nano- und/oder Mikrostruktur des Stempels beispielsweise durch Gießen des PDMS mittels einer Gießform einbringbar ist. Zusätzlich oder alternativ können die Nano- und/oder Mikrostrukturen in die Makro-Oberfläche des Stempels durch Erodieren oder Mikrofräsen eingebracht werden. Neben PDMS kann der Stempel auch aus Metall, beispielsweise Stahl, oder Silizium oder aus einer Kombination mehrerer Materialien, wie z.B. Stahl mit nickelgalvanischen Strukturen ausgebildet sein.

Die Erfindung führt auch auf ein Substrat, welches mittels des zuvor beschriebenen Verfahrens mit einer Nano- und/oder Mikrostruktur versehen wurde. Beispielsweise kann es sich bei dem Substrat um ein Polymer handeln, auf das eine elektrisch leitende Substanz aufgedruckt ist (wurde). Bevorzugt handelt es sich bei dem Substrat um ein Polymer, das mit einer nano- und/oder mikro-bioaktiven Struktur versehen wurde.

### Kurze Beschreibung der Zeichnungen

Weitere Vorteile, Merkmale und Einzelheiten der Erfindung ergeben sich aus der nachfolgenden Beschreibung bevorzugter

Ausführungsbeispiele sowie anhand der Zeichnungen. Diese zeigen in:
- Fig. 1:: ein Substrat mit einer dreidimensionalen Makro-Oberfläche,
- Fig. 2:: einen Stempel mit einer nano- und/oder mikrostrukturierten Stempel-Makro-Oberfläche, die formkongruent zu der Makro-Oberfläche des in Fig. 1 gezeigten Substrates ausgebildet ist,
- Fig. 3:: den in Fig. 2 gezeigten Stempel nach der Beaufschlagung mit einer aufzudruckenden Substanz,
- Fig. 4:: den Stempel gemäß Fig. 3 nach seiner Ausrichtung zu dem Substrat gemäß Fig. 1 beim Druckvorgang,
- Fig. 5:: das mit einer Nano- und/oder Mikrostruktur bedruckte Substrat,
- Fig. 6:: das Substrat gemäß Fig. 5 nach einem weiteren Druckvorgang (mehrfachbeschichtetes Substrat).

### Ausführungsformen der Erfindung

In den Figuren sind gleiche Bauteile und Bauteile mit der gleichen Funktion mit den gleichen Bezugszeichen gekennzeichnet.

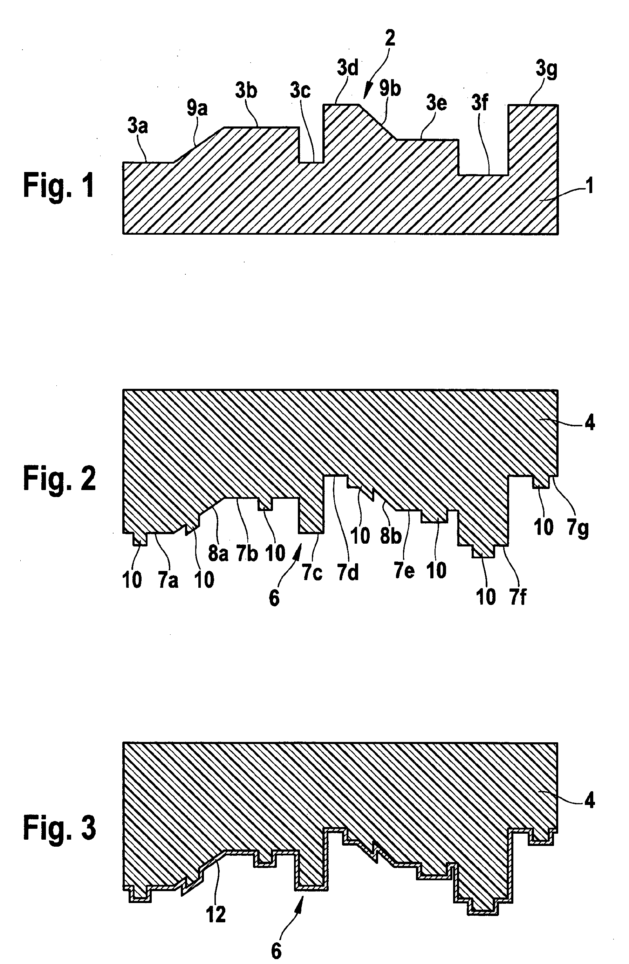

In Fig. 1 ist ein Substrat 1, in diesem Fall ein Polymer, gezeigt. Das Substrat 1 weist eine dreidimensionale Makro-Oberfläche 2 mit einer Vielzahl von Ebenen 3a bis 3g auf, die sich in unterschiedlichen Höhenpositionen befinden, wobei die Makro-Höhendifferenz zwischen den einzelnen Ebenen 3a bis 3g im Bereich von etwa 10 µm bis etwa 500 µm liegt. Es sind auch Höhenunterschiede im Millimeter- und/oder Zentimeterbereich realisierbar.

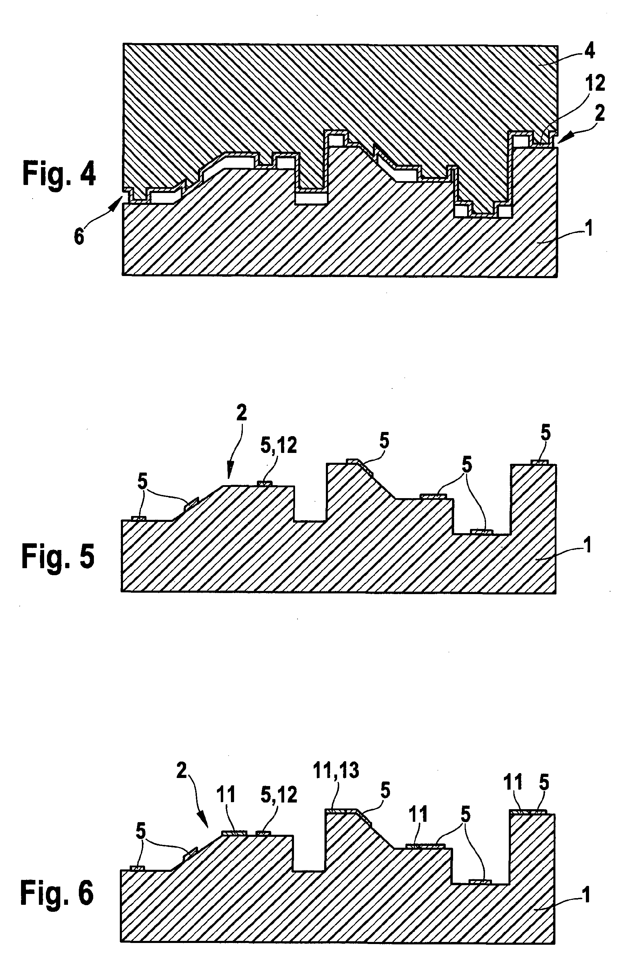

Auf diese dreidimensionale Makro-Oberfläche 2 soll mittels eines in Fig. 2 gezeigten Stempels 4 eine in Fig. 5 gezeigte Nano- und/oder Mikrostruktur 5 aufgebracht werden. Der hierzu zur Anwendung kommende Stempel 4 gemäß Fig. 2 weist als Stempelfläche eine Stempel-Makro-Oberfläche 6 auf, die formkongruent zur Makro-Oberfläche 2 des Substrates 1 ausgebildet ist. Insbesondere sind in Fig. 2 sieben in unterschiedlichen Höhenpositionen angeordnete Ebenen 7a bis 7g zu erkennen, die mit den Ebenen 3a bis 3g des Substrates 1 zur Deckung bringbar sind. Der Stempel 4 passt hinsichtlich seiner Stempel-Makro-Oberfläche 6 zu der Makro-Oberfläche 2 des Substrates 1 wie ein Schlüssel zu einem Schloss. Wie weiterhin aus Fig. 2 ersichtlich ist, sind die Ebenen 7a bis 7g sowie zwei Schrägabschnitte 8a, 8b, die zu entsprechenden, formkongruenten Schrägabschnitten 9a, 9b des Substrates 1 gemäß Fig. 1 passen, mit einer Stempel-Nano- und/oder Mikrostruktur 10 versehen.

Zum Aufbringen der in Fig. 5 gezeigten Nano- und/oder Mikrostruktur 5 auf das Substrat 1 ist es notwendig, den Stempel 4 mit einer aufzudruckenden Substanz 12 zu beschichten. Ein derartig beschichteter Stempel 4, der in diesem Ausführungsbeispiel durch Besprühen mit der Substanz 12 beschichtet wurde, ist in Fig. 3 gezeigt.

Vor oder nach dem Beschichten mit der Substanz 12 werden das Substrat 1 und der Stempel 4 relativ zueinander ausgerichtet, so dass die Makro-Oberflächen 2, 6 des Substrates 1 und des Stempels 4 miteinander zur Deckung bringbar sind. Daraufhin werden das Substrat 1 und der Stempel 4 relativ aufeinanderzubewegt, wobei es denkbar ist, ausschließlich das Substrat oder ausschließlich den Stempel oder aber sowohl das Substrat 1 als auch den Stempel 4 zu verstellen.

Bei dem in Fig. 4 dargestellten Stempelvorgang wird die Substanz 12 von in Richtung des Substrates 1 weisenden Erhöhungen der Stempel-Nano- und/oder Mikrostruktur 10 an das Substrat 1 abgegeben. Hieraus resultiert nach dem Entfernen des Stempels 4 die in Fig. 5 gezeigte Nano- und/oder Mikrostruktur 5 auf der Makro-Oberfläche 2 des Substrates 1. Die Stempel-Nano- und/oder Mikrostruktur 10 und die erzeugte Nano- und/oder Mikrostruktur 5 auf dem Substrat 1 sind dabei im Wesentlichen spiegelsymmetrisch.

Bei Bedarf erfolgt nun eine Fixierung der frisch aufgestempelten Nano- und/oder Mikrostruktur 5. Je nach Beschaffenheit der Substanz 12 ist es denkbar die Fixierung schon während des in Fig. 4 gezeigten Stempelvorgangs durchzuführen oder zumindest zu beginnen. Bevorzugt erfolgt die Fixierung jedoch nach der Entfernung des Stempels 4 von dem Substrat 1.

In Fig. 6 ist das Substrat 1 gemäß Fig. 5 mit einer erweiterten Nano- und/oder Mikrostruktur 5 gezeigt. In dem gezeigten Ausführungsbeispiel wurde hierzu eine zusätzliche Nano- und/oder Mikrostruktur 11 durch erneutes Bedrucken des in Fig. 5 gezeigten Substrates 1 auf das Substrat 1 aufgebracht. Hierzu wurde eine von der die Nano- und/oder Mikrostruktur 5 bildende Substanz 12 unterschiedliche Substanz 13 und ein von dem in Fig. 2 gezeigten Stempel unterschiedlich nano- und/oder mikrostrukturierter Stempel, jedoch mit einer identischen Stempel-Makro-Oberfläche eingesetzt. Wie sich aus Fig. 6 ergibt, befindet sich die zusätzliche Nano- und/oder Mikrostruktur 11 neben der zuvor aufgebrachten und gegebenenfalls fixierten Nano- und/oder Mikrostruktur 5. Zusätzlich oder alternativ ist es möglich, die zusätzliche Nano- und/oder Mikrostruktur 11 auf die bereits aufgebrachte Nano- und/oder Mikrostruktur 5 aufzudrucken.

## Patentansprüche

1. Verfahren zum Aufdrucken einer Nano- und/oder Mikrostruktur (5, 11) auf ein Substrat (1) mit einer dreidimensionalen Makro-Oberfläche (2), mit
- Aufbringen einer Substanz (12, 13) mit einer, zumindest abschnittsweise, zur Makro-Oberfläche (2) des Substrates (1) formkongruenten dreidimensionalen Stempel-Makro-Oberfläche (6), die mit einer Stempel-Nano- und/oder Mikrostruktur (10) versehen ist;
- Positionieren des Stempels (4) relativ zu dem Substrat (1),
- Zusammenführen von Stempel (4) und Substrat (1) und dadurch Aufdrucken der Substanz (12, 13) als Nano- und/oder Mikrostruktur (5, 11) auf das Substrat (1),
**dadurch gekennzeichnet,**
**dass** die Substanz (12, 13) bioaktives Material, insbesondere Proteine und/oder Antikörper, umfasst, oder ausschließlich aus solchem besteht.

2. Verfahren nach einem der Anspruch 1,
**dadurch gekennzeichnet,**
**dass** die Substanz (12, 13) flüssig, vorzugsweise pastös, und/oder pulverförmig ist.

3. Verfahren nach einem der vorhergehenden Ansprüche,
**dadurch gekennzeichnet,**
**dass** die Substanz (12, 13) elektrisch leitfähige Partikel, insbesondere zum Aufbringen elektrischer Bauteile, vorzugsweise von Leiterbahnen und/oder passiven und/oder aktiven Bauelementen, umfasst oder ausschließlich aus solchen besteht.

4. Verfahren nach einem der vorhergehenden Ansprüche,
**dadurch gekennzeichnet,**
**dass** die Substanz (12, 13) ein Ätzstoppmaterial, insbesondere für einen nachfolgenden Ätzschritt, vorzugsweise mittels Plasma, umfasst, oder ausschließlich aus solchem besteht.

5. Verfahren nach Anspruch 4,
**dadurch gekennzeichnet,**
**dass** die aufgestempelte Substanz (12, 13), insbesondere durch Bestrahlen und/oder Erwärmen und/oder Lagern in einer Fixiergasatmosphäre, fixiert wird.

6. Verfahren nach einem der vorhergehenden Ansprüche,
**dadurch gekennzeichnet,**
**dass** das Aufdrucken der Substanz (12, 13) auf das Substrat (1) unter Vakuum oder Überdruck durchgeführt wird.

7. Verfahren nach einem der vorhergehenden Ansprüche,
**dadurch gekennzeichnet,**
**dass** ein Stempel (4) mit einer Stempel-Nano- und/oder Mikrostruktur (10) verwendet wird, die unterschiedlich tiefe und/oder breite Strukturabschnitte aufweist.

8. Verfahren nach einem der vorhergehenden Ansprüchen,
**dadurch gekennzeichnet,**
**dass** nach dem Aufdrucken und gegebenenfalls Fixieren der Substanz (12, 13) nochmals eine Substanz, insbesondere mit einem anderen Stempel (1), insbesondere auf und/oder neben die bereits aufgebrachte Substanz (12, 13), auf das Substrat (1) aufgedruckt wird.

9. Verfahren nach einem der vorhergehenden Ansprüche,
**dadurch gekennzeichnet,**
**dass** das Substrat (1) während des Aufdruckens mittels des Stempels (4) von einer Halterung mit einer an die Form des Substrates (1) angepassten dreidimensionalen Makro-Oberfläche (6) gestützt wird.

10. Substrat mit einer dreidimensionalen Stempel-Makro-Oberfläche, auf die mittels eines Verfahrens nach einem der Ansprüche 1 bis 9 eine Nano- und/oder Mikrostruktur (5) aufgedruckt ist, dass ein bioaktives Material umfasst oder ausschließlich aus solchem besteht.

## Claims

1. Method for printing a nanostructure and/or microstructure (5, 11) onto a substrate (1) with a three-dimensional macro-surface (2), with
- application of a substance (12, 13) with a three-dimensional stamp macro-surface (6) which is congruent in terms of shape at least in sections with respect to the macro-surface (2) of the substrate (1) and is provided with a stamp nanostructure and/or microstructure (10),
- positioning of the stamp (4) relative to the substrate (1),
- bringing together of the stamp (4) and the substrate (1) and, as a result, printing of the substance (12, 13) as a nanostructure and/or microstructure (5, 11) onto the substrate (1),
**characterized in that** the substance (12, 13) comprises bioactive material, in particular proteins and/or antibodies, or consists exclusively thereof.

2. Method according to Claim 1, **characterized in that** the substance (12, 13) is liquid, preferably pasty, and/or pulverulent.

3. Method according to either of the preceding claims, **characterized in that** the substance (12, 13) comprises electrically conductive particles, in particular for applying electric components, preferably conductor tracks and/or passive and/or active elements, or consists exclusively thereof.

4. Method according to one of the preceding claims, **characterized in that** the substance (12, 13) comprises an etch-stop material, in particular for a following etching step, preferably by means of plasma, or consists exclusively thereof.

5. Method according to Claim 4, **characterized in that** the stamped-on substance (12, 13) is fixed, in particular by way of irradiating and/or heating and/or storing in a fixing gas atmosphere.

6. Method according to one of the preceding claims, **characterized in that** the printing of the substance (12, 13) onto the substrate (1) is carried out under vacuum or positive pressure.

7. Method according to one of the preceding claims, **characterized in that** a stamp (4) is used with a stamp nanostructure and/or microstructure (10) which have/has structure sections of different depth and/or width.

8. Method according to one of the preceding claims, **characterized in that**, after the printing and possibly fixing of the substance (12, 13), a substance is once again printed onto the substrate (1), in particular by way of a different stamp (1), in particular onto and/or next to the substance (12, 13) which has already been applied.

9. Method according to one of the preceding claims, **characterized in that**, during printing by means of the stamp (4), the substrate (1) is supported by a holder with a three-dimensional macro-surface (6) which is adapted to the shape of the substrate (1).

10. Substrate having a three-dimensional stamp macro-surface, onto which a nanostructure and/or microstructure (5) is/are printed by means of a method according to one of Claims 1 to 9, which nanostructure and/or microstructure (5) comprise/comprises a bioactive material or consist/consists exclusively thereof.

## Revendications

1. Procédé d'impression d'une nanostructure et/ou d'une microstructure (5, 11) sur un substrat (1) présentant une macrosurface tridimensionnelle (2), le procédé comportant les étapes qui consistent à :
appliquer une substance (12, 13) à l'aide d'une macrosurface (6) de tampon tridimensionnelle, de forme congruente au moins en partie à celle de la macrosurface (2) du substrat (1) et dotée d'une nanostructure et/ou microstructure (10) de tampon,
positionner le tampon (4) par rapport au substrat (1),
approcher le tampon (4) du substrat (1) et ainsi imprimer la substance (12, 13) en tant que nanostructure et/ou microstructure (5, 11) sur le substrat (1),
**caractérisé en ce que**
la substance (12, 13) comporte un matériau bioactif, en particulier des protéines et/ou des anticorps, ou est exclusivement constituée de ce dernier.

2. Procédé selon la revendication 1, **caractérisé en ce que** la substance (12, 13) est fluide, de préférence pâteuse et/ou pulvérulente.

3. Procédé selon l'une des revendications précédentes, **caractérisé en ce que** la substance (12, 13) comporte des particules électriquement conductrices, en particulier pour l'application de composants électriques, de préférence de pistes conductrices et/ou de composants passifs et/ou actifs, ou est exclusivement constituée de ces dernières.

4. Procédé selon l'une des revendications précédentes, **caractérisé en ce que** la substance (12, 13) comporte un matériau de blocage de gravure, en particulier pour une étape ultérieure de gravure, de préférence au moyen d'un plasma, ou est exclusivement constituée de ce dernier.

5. Procédé selon la revendication 4, **caractérisé en ce que** la substance (12, 13) appliquée par tampon, est fixée en particulier par irradiation, chauffage ou entreposage dans une atmosphère de gaz de fixation.

6. Procédé selon l'une des revendications précédentes, **caractérisé en ce que** l'impression de la substance (12, 13) sur le substrat (1) est réalisée sous vide ou sous surpression.

7. Procédé selon l'une des revendications précédentes, **caractérisé en ce qu'**un tampon (4) doté d'une nanostructure et/ou d'une microstructure de tampon (10) qui présente des parties structurées de différentes profondeurs et/ou de différentes largeurs est utilisé.

8. Procédé selon l'une des revendications précédentes, **caractérisé en ce qu'**après l'impression et éventuellement la fixation de la substance (12, 13), une substance est encore imprimée sur le substrat (1), en particulier à l'aide d'un autre tampon (1) et en particulier sur et/ou à côté de la substance (12, 13) déjà appliquée.

9. Procédé selon l'une des revendications précédentes, **caractérisé en ce que** pendant l'impression au moyen du tampon (4), le substrat (1) est soutenu par un support qui présente une macrosurface (6) tridimensionnelle adaptée à la forme du substrat (1).

10. Substrat doté d'une macrosurface tridimensionnelle de tampon sur laquelle une nanostructure et/ou microstructure (5) est imprimée au moyen d'un procédé selon l'une des revendications 1 à 9, laquelle nanostructure et/ou microstructure comporte un matériau bioactif ou est exclusivement constituée de ce dernier.
